# EUROPÄISCHE PATENTSCHRIFT

(11) **EP 3 464 682 B1**
(45) Veröffentlichungstag und Bekanntmachung des Hinweises auf die Patenterteilung: **17.03.2021**
(21) Anmeldenummer: 17723319.4
(22) Anmeldetag: 04.05.2017
(51) Int. Cl.: C23G 3/02, C25D 7/06, C23C 14/56, C23C 14/02, C23G 1/08, C25D 5/36

(54) **VERFAHREN UND ANLAGE ZUM BESCHICHTEN EINES VERZUNDERTEN WARMBANDS**
METHOD AND INSTALLATION FOR COATING A SCALED HOT-ROLLED STRIP
PROCÉDÉ ET INSTALLATION POUR REVÊTIR UN FEUILLARD À CHAUD CALAMINÉ

(30) Priorität: 25.05.2016 DE 102016209093; 30.11.2016 DE 102016223743
(43) Veröffentlichungstag der Anmeldung: 10.04.2019
(73) Patentinhaber: SMS Group GmbH, 40237 Düsseldorf (DE)
(72) Erfinder: JAENECKE, Markus, 42653 Solingen (DE)
(74) Vertreter: Kross, Ulrich
(86) Internationale Anmeldenummer: PCT/EP2017/060638
(87) Internationale Veröffentlichungsnummer: WO 2017/202587

(56) Entgegenhaltungen:
- WO-A1-01/20054
- WO-A2-2017/001283
- DE-A1- 1 621 042
- DE-A1- 19 926 102
- DE-A1-102007 046 226

## Beschreibung

Die Erfindung betrifft ein Verfahren und eine Anlage zum Beschichten eines verzunderten Warmbands.

Bei der Herstellung von verzinktem Band ist es nach dem Stand der Technik bekannt, ein warmgewalztes Vorwand auf einer Beizlinie zu beizen. Das Beizen dient dazu, Zunder- bzw. Oxidschichten von den Oberflächen des Warmbands zu entfernen. Das Entfernen von solchen Schichten dient der Vorbereitung des Kaltwalzens und/oder zum Aufbringen einer Schutzschicht, z.B. durch Verzinken, die dem Korrosionsschutz der Oberfläche des Warmbands dient.

Zum Verzinken der Oberflächen eines Warmbands ist es z.B. beim Feuerverzinken bekannt, das Warmband zunächst in einem Durchlaufofen auf eine Temperatur von etwa 500 °C zu erhitzen, um anschließend das Warmband durch eine Badschmelze von geschmolzenen Zink (bei etwa 450 °C) zu führen. Sobald das Warmband die Badschmelze verlässt, wird mittels Luftabstreifdüsen die Beschichtungsstärke für das Zink eingestellt.

Die Verzinkung von Warmband nach dem Prinzip des Schmelztauchveredelns bzw. dem Feuerverzinken unterliegt dem Nachteil, dass hierbei die Bandoberfläche des Warmbands deutlich über 400 °C erhitzt wird. Durch diese Wärmebehandlung verliert das Warmband einen Teil seiner zuvor im Warmwalzwerk eingestellten Materialeigenschaften.

Aus EP 0 863 222 A1 ist es bekannt, den Beiz - und Verzinkungsprozess mit einem Kaltwalzprozess in einer Gesamtanlage in einer durchlaufenden Linie permanent zu koppeln. Hierbei wird das Warmband zusätzlich zum Verzinken stets auch einem Kaltwalzen unterzogen, um das Warmband auf eine gewünschte Fertigdicke zu bringen. Die Durchführung eines Kaltwalzens ist mit dem Nachteil verbunden, dass sich dabei das Warmband verfestigt und/oder seine voreingestellten Materialeigenschaften verliert. In einem anschließenden Glühprozess müssen die Materialeigenschaften des Warmbands dann wiederhergestellt werden.

Aus DE 199 26 102 A1 sind ein gattungsgemäßes Verfahren zum Beschichten eines verzunderten Warmbands mit den Merkmalen nach dem Oberbegriff des Anspruchs 1, und eine gattungsgemäße Anlage zum Beschichten eines verzunderten Warmbands mit den Merkmalen nach dem Oberbegriff des Anspruchs 6 bekannt.

Aus WO 2001/20054 A1 sind ein Verfahren und eine entsprechende Anlage zum Beschichten eines Metallbandes bekannt. Hierbei wird ein zu einem Bund gewickeltes Metallband zunächst abgewickelt, und anschließend der Bandanfang des Metallbandes in eine Durchlauf-Beschichtungskammer eingefädelt, durch die Durchlauf-Beschichtungskammer hindurchgeführt und das Metallband nach dem Beschichten dann zu einem Bund gewickelt. Das Bandende des Metallbandes wird aus der Durchlauf-Beschichtungskammer ausgefädelt, wobei darauffolgend weitere, ebenfalls jeweils zu einem Bund gewickelte Metallbänder in gleicher Weise einzeln durch die Durchlauf-Beschichtungskammer hindurchgeführt werden.

Aus DE 1 621 042 A1 ist ein elektrolytisches Beschichten der Oberflächen eines Warmbandes bekannt, nachdem dieses zunächst mittels einer Beizeinrichtung geeignet vorbereitet worden ist.

Aus DE 10 2007 046 226 A1 ist ein Verfahren zur Herstellung eines Leitblechs bekannt, bei dem auf eine Oberfläche eines ersten Metallblechs eine thermoplastische Polymerschaumschicht aufgebracht wird, wobei anschließend ein zweites Metallband auf diese Polymerschaumschicht aufgebracht wird, und dann das erste Metallband, die thermoplastische Polymerschaumschicht und das zweite Metallband durch Temperatureinwirkung und Druckausüben miteinander zu einem Verbundbauteil verbunden werden.

Aus DE 10 2015 200 764 A1 sind ein Verfahren und eine Anlage zum Herstellen von schmelztauchbeschichtetem, warmgewalztem Stahlband bekannt. Im Anschluss an eine Verzinkung des Stahlbands wird durch eine Kaltumformung auf die Bandoberfläche des Stahlbands durch Dressieren eine gezielte Oberflächenstrukturierung eingebracht, die somit die Bandoberflächenstruktur des Fertigprodukts bildet.

Entsprechend liegt der Erfindung die Aufgabe zugrunde, verzunderte Warmbänder in einem Prozessschritt metallisch zu beschichten, wobei voreingestellte Materialeigenschaften des Warmbands nicht verlorengehen sollen.

Diese Aufgabe wird durch ein Verfahren mit den in Anspruch 1 angegebenen Merkmalen, und durch eine Anlage gemäß Anspruch 6 gelöst. Vorteilhafte Weiterbildungen der Erfindung sind in den abhängigen Ansprüchen definiert.

Ein Verfahren nach der vorliegenden Erfindung dient zum Beschichten eines verzunderten Warmbands, und umfasst zumindest folgende Schritte:
(i) Bereitstellen eines Warmbands in Form eines warmgewalztes Vorbands,
(ii) Vorbereiten der Oberflächen des Warmbands, und
(iii) Beschichten des Warmbands an zumindest einer vorbereiteten Oberfläche davon, wobei das Beschichten bei einer Temperatur von ≤ 100 °C und unmittelbar nach dem Entzundern des Warmbands durchgeführt wird,
wobei nach dem Schritt (iii) für das Warmband zumindest ein weiterer Behandlungsschritt (iv) durchgeführt wird, bei dem das Warmband mit einer zusätzlichen Beschichtung bestehend aus einer Kunststoff-Folienkaschierung versehen wird.

In gleicher Weise sieht die Erfindung eine Anlage zum Beschichten eines verzunderten Warmbands vor, die eine durchlaufende Behandlungslinie umfasst, in der das Warmband in einer Bewegungsrichtung bewegt wird, wobei in de Behandlungslinie eine Beizeinrichtung zum Vorbereiten der Oberflächen des Warmbands und zumindest eine erste Beschichtungseinnchtung vorgesehen sind. Mittels der ersten Beschichtungseinrichtung kann auf zumindest eine vorbereitete Oberfläche des Warmbands eine Beschichtung aufgebracht werden, z.B. in Form einer Zinkschicht. Hierbei ist die erste Beschichtungseinrichtung derart ausgebildet ist, dass, falls sie in Betrieb gesetzt wird, das Beschichten des Warmbands auf zumindest einer Seite davon bei einer Temperatur von ≤ 100 °C erfolgt. Des Weiteren ist eine zweite Beschichtungseinrichtung vorgesehen ist, die - in der Bewegungsrichtung des Warmbands gesehen - stromabwärts der ersten Beschichtungseinrichtung angeordnet ist, wobei mittels der zweiten Beschichtungseinrichtung auf zumindest eine Oberfläche des Warmbands eine zusätzliche Beschichtung bestehend aus einer Kunststoff-Folienkaschierung aufgebracht wird.

Der Erfindung liegt die wesentliche Erkenntnis zugrunde, dass ein Warmband im Zuge seiner Beschichtung seine zuvor in einem Warmwalzwerk eingestellten Materialeigenschaften beibehält bzw. nicht verliert, weil alle Prozesse gemäß der vorliegenden Erfindung bei niedrigen Temperaturen, die ≤ 100 °C liegen, ablaufen. Anders ausgedrückt, bleiben die voreingestellten Materialeigenschaften eines Warmbands während des Beizens und einem anschließenden Beschichten, z.B. einem Verzinken, weitestgehend erhalten. Ein Warmband wird direkt nach dem Warmwalzwerk auf die Behandlungslinie der erfindungsgemäßen Anlage gebracht, und dort in einem kontinuierlichen Prozess in Bezug auf seine Oberflächen vorbereitet, z.B. entzundert, und anschließend metallisch beschichtet. Für die Durchführung der Erfindung ist von besonderer Bedeutung, dass ein Beschichten des Warmbands durchgeführt wird, unmittelbar nachdem dessen Oberfläche(n) für das Beschichten vorbereitet worden sind, z.B. durch ein vorgeschaltetes Beizen. Jedenfalls wird das Warmband hierbei keinen Prozessen unterzogen, z.B. in Form eines Kaltwalzens oder dergleichen, bei denen die voreingestellten Materialeigenschaften des Warmbands verändert oder beeinträchtigt würden.

Die sonst üblichen Zwischentransporte, Zwischenlagerungen, Zwischenbehandlungen der Oberfläche, zusätzlichen Bandverbindungen und zusätzlichen Schrottschnitte können bei Durchführung der vorliegenden Erfindung entfallen.

In vorteilhafter Weiterbildung der Erfindung wird beim Schritt (i) des Verfahrens das Vorbereiten der Oberflächen des Warmbands mittels einer Beizeinrichtung durchgeführt. Dies hat den Vorteil, dass dadurch nicht nur die beim Warmwalzen entstandene Zunderschichten, sondern auch eine auf dem Warmband gebildete Oxidschicht wirkungsvoll von den Oberflächen des Warmbands entfernt wird.

In vorteilhafter Weiterbildung der Erfindung kann das Beschichten des Warmbands mittels der ersten Beschichtungseinrichtung nach dem Prinzip der Elektrolyse durchgeführt werden. Dies gilt insbesondere für den Schritt (iii) des erfindungsgemäßen Verfahrens. Alternativ hierzu ist es auch möglich, das Beschichten des Warmbands mittels der ersten Beschichtungseinrichtung nach dem Prinzip einer physikalischen Gasabscheidung (=PVD-Prinzip; = *physical vapour deposition*) durchzuführen. Zweckmäßigerweise erfolgt das Beschichten des Warmbands an einer oder beiden Oberflächen davon, d.h. an dessen Oberseite und/oder Unterseite.

In vorteilhafter Weiterbildung der Erfindung wird das Warmband, bevor seine Oberflächen für das anschließende Beschichten vorbereitet werden, an seinen Seitenrändern beschnitten. Dies gewährleistet einen sauberen Coil mit definierten und beschichteten Seitenrändern. Ein solches Beschneiden des Warmbands kann durch eine Schere durchgeführt werden, die - in der Bewegungsrichtung des Warmbands innerhalb der Behandlungslinie gesehen - stromaufwärts der Beizeinrichtung angeordnet ist.

Dadurch, dass im Anschluss an das Beschichten des Warmbands eine weitere zusätzliche Beschichtung auf das Warmband in Form einer Kunststoff-Folienkaschierung aufgebracht wird, werden die Oberflächen des Warmbands zusätzlich gegen Umgebungseinflüsse wirksam geschützt. Zu diesem Zweck ist - in der Bewegungsrichtung des Warmbands innerhalb der Behandlungslinie gesehen - stromabwärts von der ersten Beschichtungseinrichtung ein Folienkaschierwerk angeordnet, durch welches das Warmband mit einer Kunststofffolie kaschiert wird. Ergänzend kann auch vorgesehen sein, das Warmband an zumindest einer Oberfläche mit einer Rollbeschichtung zu versehen, z.B. durch einen Kontakt mit entsprechenden Rollen, die mit einem Medium, das auf zumindest eine Oberfläche des Warmbands aufzubringen ist, getränkt sind. Beispielsweise kann dadurch das Warmband mit einer acrylischen Beschichtung und/oder mit einer chromatischen Beschichtung oder dergleichen versehen werden.

In vorteilhafter Weiterbildung der Erfindung kann vorgesehen sein, dass für das Warmband an dessen Oberflächen eine vorbestimmte Rauheit eingestellt wird. Zu diesem Zweck wird - in der Bewegungsrichtung des Warmbands innerhalb der Behandlungslinie gesehen - stromabwärts von der ersten Beschichtungseinrichtung ein Dressiergerüst angeordnet, durch welches das Warmband geleitet wird. Diesbezüglich wird gesondert darauf hingewiesen, dass beim Einbringen einer gewünschten Rauheit in die Oberflächen des Warmbands dessen voreingestellten Materialeigenschaften nicht verloren gehen.

In vorteilhafter Weiterbildung der Erfindung kann vorgesehen sein, auf zumindest eine Oberfläche des Warmbands eine Ölung aufzubringen. Hierzu ist es zweckmäßig, insbesondere stromabwärts von der zweiten Beschichtungseinrichtung eine Einölmaschine vorzusehen, mittels der auf eine Oberseite und/oder eine Unterseite des Warmbands eine Ölung aufgebracht werden kann

In vorteilhafter Weiterbildung der Erfindung kann für die erfindungsgemäße Anlage vorgesehen sein, dass - bei Bedarf - die erste Beschichtungseinrichtung nicht in Betrieb gesetzt wird, wenn das Warmband durch die Behandlungslinie bewegt bzw. transportiert wird. In dieser Weise ist es möglich, für das Warmband z.B. nur das Beizen durchzuführen, ohne jedoch das Warmband anschließend zu verzinken. Durch ein solches Abschalten eines Teilprozesses, bei dem genannten Beispiel das Verzinken mittels der ersten Beschichtungseinrichtung, lässt sich das mögliche Produktspektrum für das Warmband vergrößern. Beispielsweise ist somit ein Beizen von Normalstahlbändern mit Beizsäure zur Erzeugung einer gebeizten und geölten Bandoberfläche möglich, indem die erste Beschichtungseinrichtung zum Aufbringen einer Zinkbeschichtung abgeschaltet wird. Dies bedeutet, dass eine Verwendung der erfindungsgemäßen Anlage auch dann möglich ist, wenn die erste Beschichtungseinrichtung außer Betrieb bleibt.

Weitere Vorteile der Erfindung bestehen aus folgenden Aspekten:
- Einsparung von Investitionskosten,
- Energieeinsparung,
- höhere Ausbringung,
- sehr kurze Produktionszeit,
- Reduktion von logistischen Operationen,
- Reduktion von Lagerflächen,
- hohe Flexibilität trotz einer Prozesskombination in der Behandlungslinie der Anlage.

Nachstehend sind Ausführungsbeispiele der Erfindung anhand einer schematisch vereinfachten Zeichnung im Detail beschrieben.

Es zeigen:
- Fig. 1: ein schematisch vereinfachtes Ablaufdiagramm zur Durchführung eines Verfahrens nach der vorliegenden Erfindung,
- Fig. 2: eine schematisch vereinfachte Seitenansicht einer erfindungsgemäßen Anlage nach einer ersten erfindungsgemäßen Ausführungsform, und
- Fig. 3-9: jeweils schematisch vereinfachte Seitenansichten einer erfindungsgemäßen Anlage nach weiteren Ausführungsformen der Erfindung.

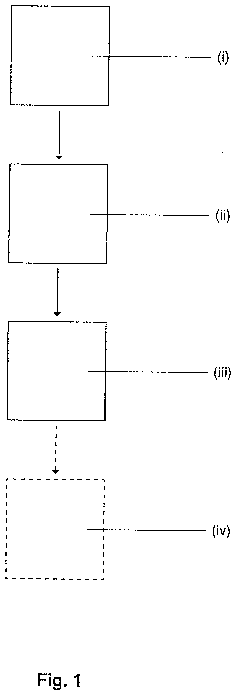

Die vorliegende Erfindung sieht ein Verfahren und eine Anlage vor, um ein verzundertes Warmband an zumindest einer Oberfläche davon zu beschichten. Fig. 1 veranschaulicht ein Ablaufdiagramm von wesentlichen Schritten des erfindungsgemäßen Verfahrens:
Zunächst wird in einem Schritt (i) ein Warmband 10 bereitgestellt. Bei einem solchen Warmband handelt es sich um ein warmgewalztes Vorband, das während eines vorgeschalteten Walzens in einem Warmwalzgerüst vorbestimmte Materialeigenschaften erhalten hat.

Anschließend wird in einem Schritt (ii) die Oberfläche des Warmbands 10 einer Vorbehandlung unterzogen, um das Aufbringen einer Beschichtung darauf vorzubereiten. Eine solche Vorbehandlung kann daraus bestehen, dass die Oberfläche(n) des Warmbands gebeizt wird bzw. werden. Hierbei wird das Warmband durch eine entsprechende Beizeinrichtung hindurchgeführt, was nachfolgend noch an anderer Stelle erläutert ist.

In einem nächsten Schritt (iii) wird dann das Warmband 10 an zumindest einer Oberfläche davon beschichtet. Bezüglich dieses Prozessschrittes wird an dieser Stelle gesondert hervorgehoben, dass das Beschichten des Warmbands 10 bei moderaten Temperaturen, d.h. bei einer Temperatur von ≤ 100 °C durchgeführt wird. Bedingt durch diese relativ geringe Temperatur ist gewährleistet, dass voreingestellte Materialeigenschaften des Warmbands erhalten bleiben.

Erfindungsgemäß ist nach dem Schritt (iii) ein weiterer Verfahrensschritt (iv) vorgesehen, der in Fig. 1 gestrichelt dargestellt ist. Bei diesem weiteren Verfahrensschritt wird eine zusätzliche Beschichtung auf das Warmband in Form einer Kunststoff-Folienkaschierung aufgebracht, die z.B. durch geeignete Rollen auf eine Oberfläche des Warmbands aufgetragen wird. Ergänzend kann auch vorgesehen sein, in dem weiteren Verfahrensschritt (iv) auf zumindest eine Oberfläche des Warmbands eine Ölung aufzutragen, z.B. durch Spritzen, Rollen oder elektrostatisch.

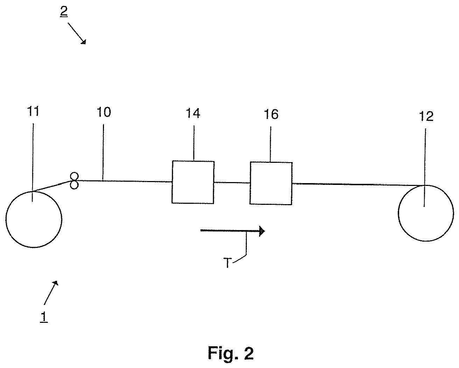

In den Fig. 2 bis 9 sind verschiedene Ausführungsformen für eine erfindungsgemäße Anlage 1 gezeigt, mit der ein Behandeln eines verzunderten Warmbands 10 möglich ist. Gleiche Merkmale für die Anlage 1 sind in der Zeichnung jeweils mit gleichen Bezugszeichen versehen.

Fig. 2 zeigt die Anlage 1 nach einer ersten Ausführungsform, in einer schematisch stark vereinfachten Seitenansicht. Die Anlage umfasst eine Behandlungslinie 2, bei der ein Warmband 10 zunächst von einer ersten Haspeleinrichtung 11 abgewickelt wird, wobei das Warmband 10 am Ende der Behandlungslinie 2 dann von einer zweiten Haspeleinrichtung 12 wieder aufgewickelt wird. Innerhalb der Behandlungslinie 2 wird das Warmband 10 in einer Bewegungsrichtung T bewegt bzw. transportiert, nämlich von der ersten Haspeleinrichtung 11 in Richtung der zweiten Haspeleinrichtung 12.

In der Behandlungslinie 2 sind eine Beizeinrichtung 14 und - stromabwärts davon - eine erste Beschichtungseinrichtung 16 angeordnet. Die Beschichtungseinrichtung 16 kann bei Bedarf an- oder abgeschaltet werden, was nachstehend noch gesondert erläutert ist.

Durch ein Behandeln des Warmbands 10 in der Beizeinrichtung 14 werden dessen Oberflächen geeignet vorbereitet, um im Anschluss daran mittels der ersten Beschichtungseinrichtung 16 auf zumindest eine Oberfläche des Warmbands 10, vorzugsweise auf beide Oberflächen davon, eine Beschichtung aufzubringen. Bei der ersten Beschichtungseinrichtung 16 kann es sich um ein elektrolytisches Tauchbad handeln, in dem die Oberflächen des Warmbands 10 verzinkt werden.

Nachdem die Oberflächen des Warmbands 10 in der Behandlungslinie 2 gebeizt und anschließend zumindest eine Oberfläche des Warmbands 10 mit einer Beschichtung, z.B. mit einer Zinkschicht, versehen worden sind, wird das Warmband 10 dann von der zweiten Haspeleinrichtung 12 wieder aufgewickelt. In dieser Weise gelingt ein metallisches Beschichten von verzundertem Warmband 10 bei nur geringen Temperaturen, ohne dass die Materialeigenschaften des Warmbands 10 verändert bzw. beeinträchtigt werden.

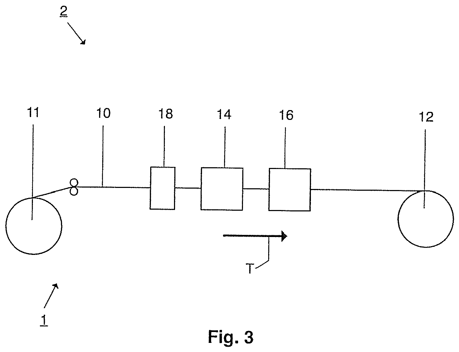

Fig. 3 zeigt eine erfindungsgemäße Anlage 1 nach einer weiteren Ausführungsform. Hierbei ist im Vergleich zur Ausführungsform von Fig. 2 - in der Bewegungsrichtung T des Warmbands 10 gesehen - stromaufwärts von der Beizeinrichtung 14 eine erste Schere 18 angeordnet. Diese erste Schere 18 dient dazu, Seitenränder des Warmbands 10 gezielt und definiert abzutrennen, so dass es möglich ist, auf der zweiten Haspeleinrichtung 12 einen "sauberen" Coil mit definierten Seitenrändern aufzuwickeln.

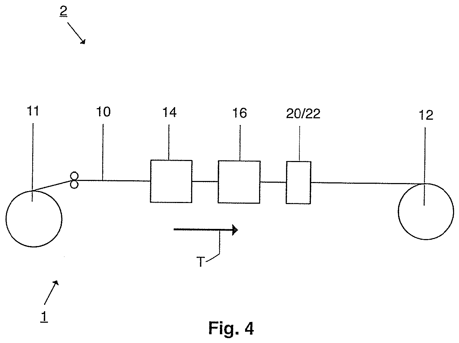

Fig. 4 zeigt eine erfindungsgemäße Anlage 1 nach einer weiteren Ausführungsform. Hierbei sind - in der Bewegungsrichtung T des Warmbands 10 gesehen - stromabwärts von der ersten Beschichtungseinrichtung ein Dressiergerüst 22 und eine zweite Beschichtungseinrichtung 20 angeordnet. Optional kann zwischen dem Dressiergerüst 22 und der zweiten Beschichtungseinrichtung 20 auch ein Streckrichter 23 angeordnet sein. Bei der zweiten Beschichtungseinrichtung 20 handelt es sich um ein Folienkaschierwerk, mittels dessen das Warmband 10 mit einer Kunststoff-Folienkaschierung versehen wird.

Das Dressiergerüst 22 dient dazu, den Oberflächen des Warmbands 10 eine definierte Rauheit zu verleihen, ohne dass dabei eine Dickenreduktion des Warmbands 10 erfolgt und dessen voreingestellte Materialeigenschaften verloren gehen.

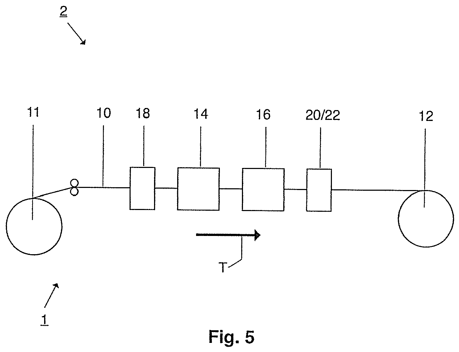

Fig. 5 zeigt eine erfindungsgemäße Anlage 1 nach einer weiteren Ausführungsform. Stromaufwärts der Beizeinrichtung 14 sind eine erste Schere 18, und stromabwärts der ersten Beschichtungseinrichtung 16 eine zweite Beschichtungseinrichtung 20 und/oder ein Dressiergerüst 22 angeordnet. Zur Vermeidung von Wiederholungen wird auf die diesbezügliche Erläuterung zu den Fig. 3 bzw. Fig. 4 verwiesen.

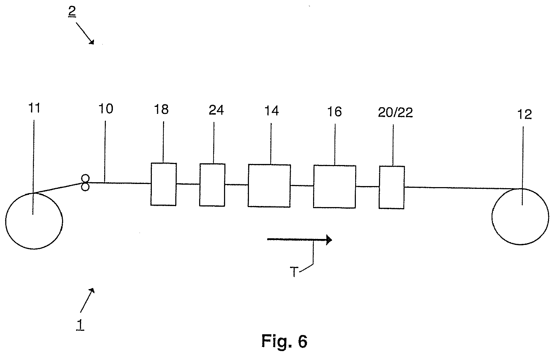

Fig. 6 zeigt eine erfindungsgemäße Anlage 1 nach einer weiteren Ausführungsform, die eine Variante zur Ausführungsform von Fig. 5 darstellt. Im Unterschied hierzu ist - in Transportrichtung T des Warmbands 10 gesehen - stromaufwärts der Beizeinrichtung 14 ein sog. "Zunderbrecher" 24 angeordnet, nämlich zwischen der Beizeinrichtung 14 und der ersten Schere 18. Bei einem solchen Zunderbrecher 24 kann es sich seiner Funktion nach um einen Streckrichter handeln, der in an sich bekannter Weise zu einem Glätten der Oberflächen des Warmbands 10 dient, ohne dass dabei jedoch die Dicke des Warmbands 10 verändert wird. Entsprechend kommt es beim Einsatz des Zunderbrechers 24 nicht zu einem Kaltwalzen des Warmbands 10, und somit auch nicht zu einer wesentlichen Veränderung von dessen Materialeigenschaften. Dies gilt in gleicher Weise auch für den Streckrichter 23 bei der Ausführungsform von Fig. 4.

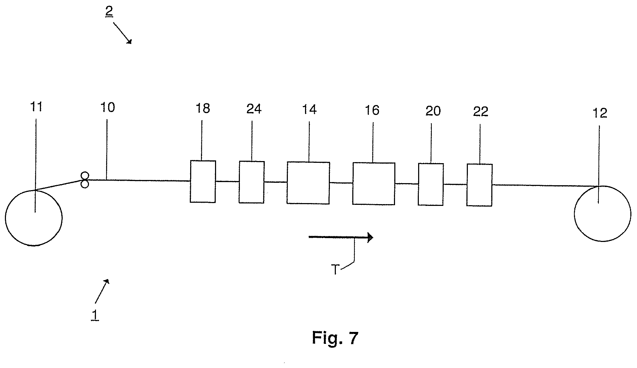

Fig. 7 zeigt eine erfindungsgemäße Anlage 1 nach einer weiteren Ausführungsform, als Variante zur Ausführungsform von Fig. 6, wonach - in Transportrichtung T des Warmbands 10 gesehen - nunmehr stromabwärts der ersten Beschichtungseinrichtung 16 sowohl eine zweite Beschichtungseinrichtung 20 als auch ein Dressiergerüst 22 angeordnet sind.

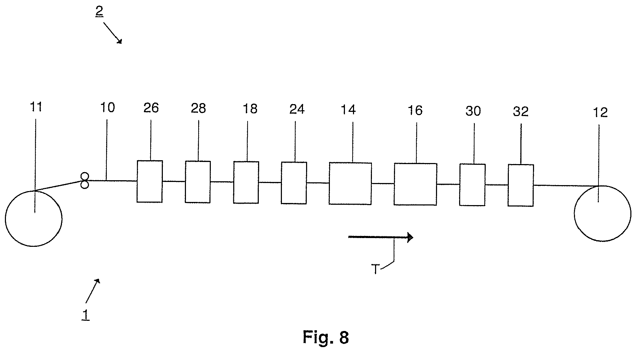

Fig. 8 zeigt eine erfindungsgemäße Anlage 1 nach einer weiteren Ausführungsform, mit der ein fortwährender Betrieb der Behandlungslinie 2 durch den Einsatz von neuen Coils möglich ist. Zu diesem Zweck sind - in Transportrichtung T des Warmbands 10 gesehen - stromaufwärts der Beizeinrichtung 14 eine Verbindungseinrichtung 26 und ein erster Schlingenspeicher 28 angeordnet. Bei der Verbindungseinrichtung 26 kann es sich um eine Schweißeinrichtung oder um eine Hefteinrichtung handeln, mit der die Randbereiche von zwei verschiedenen Coils miteinander verschweißt bzw. geheftet werden können. Wenn bei einem Wechsel eines Coils dessen Bandanfang mit dem Bandende eines vorhergehenden Coils zu verbinden ist, kann dies dank des ersten Schlingenspeichers 28 erfolgen, in dem zuvor eine ausreichende Menge bzw. Strecke an Warmband gepuffert bzw. gespeichert worden ist. In gleicher Weise sind - in Transportrichtung T des Warmbands 10 gesehen stromabwärts von der zweiten Schere - stromabwärts der ersten Beschichtungseinrichtung ein zweiter Schlingenspeicher 30 und eine zweite Schere 32 angeordnet. Dank dieser Elemente ist es möglich, eine Charge eines Coils des Warmbands 12 auf der zweiten Haspeleinrichtung 12 aufzuwickeln und an der zweiten Haspeleinrichtung 12 hierzu einen entsprechenden Wechsel vorzunehmen.

Bei der Ausführungsform von Fig. 8 ist ferner vorgesehen, auf das Warmband 10 eine Ölung aufzubringen. Zu diesem Zweck ist stromabwärts von der zweiten Schere 32 eine Einölmaschine 34 angeordnet, mittels der auf eine Oberseite und/oder Unterseite des Warmbands 10 aufgebracht werden kann.

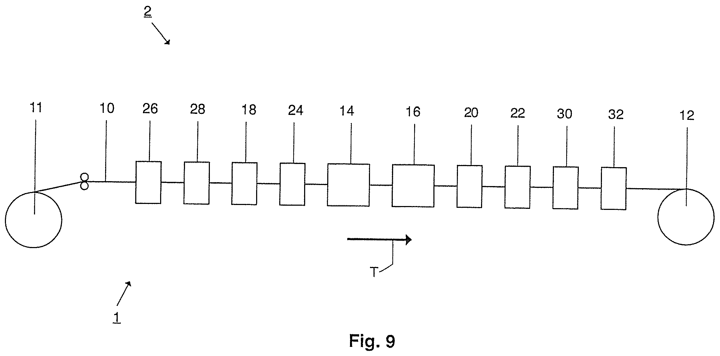

Fig. 9 zeigt eine erfindungsgemäße Anlage 1 nach einer weiteren Ausführungsform, die einer Kombination der Ausführungsformen nach den Fig. 7 und 8 entspricht. Somit sind bei der Ausführungsform von Fig. 9, stromabwärts von der ersten Beschichtungseinrichtung 16, nunmehr eine zweite Beschichtungseinrichtung 20, ein Dressiergerüst 22, ein zweiter Schlingenspeicher 30, eine zweite Schere 32 und eine Einölmaschine 34 angeordnet. Zur Vermeidung von Wiederholungen wird auf die entsprechenden Erläuterungen zu Fig. 7 und Fig. 8 verwiesen.

Bei den vorstehend genannten Ausführungsformen nach den Fig. 3-9 kommen im Vergleich zur Ausführungsform von Fig. 2, neben der Beizeinrichtung 14 und der ersten Beschichtungseinrichtung 16, folgende zusätzliche Anlagenkomponenten hinzu:
- erste Schere 18,
- zweite Beschichtungseinrichtung 20,
- Dressiergerüst 22,
- Streckrichter 24,
- Verbindungseinrichtung 26,
- erster Schlingenspeicher 28,
- zweiter Schlingenspeicher 30,
- zweite Schere 32, und/oder
- Einölmaschine 34.

Bezüglich dieser zusätzlichen Anlagenkomponenten versteht sich, dass eine Kombination davon mit der Ausführungsform von Fig. 2 auch in anderer Weise möglich ist, als wie es durch die Darstellung in den Figuren 3 bis 9 gezeigt und erläutert worden ist. Somit ist es möglich, diese Anlagenkomponenten auch in anderen Kombinationen und ggf. in einer Position in der Behandlungslinie 2 der Anlage 1 einzusetzen, die von der dargestellten Zeichnung abweichend sind.

Schließlich wird darauf hingewiesen, dass bei allen der obigen Ausführungsformen die Anlage 1 auch in der Weise betrieben werden kann, dass die erste Beschichtungseinrichtung 16, mittels der normalerweise z.B. eine Verzinkung auf das Warmband 10 aufgebracht wird, abgeschaltet wird. Entsprechend durchläuft dann das Warmband 10 die Behandlungslinie 2, ohne dass dabei die Oberflächen des Warmbands 10 verzinkt werden. In dieser Weise kann durch die Anlage 1, wenn die erste Beschichtungseinrichtung 16 abgeschaltet ist, ein Beizen von Normalstahlbändern mit Beizsäure zur Erzeugung eines Warmbands 10 mit gebeizten und geölten Oberflächen realisiert werden. Hierbei werden die geölten Oberflächen des Warmbands 10 mittels der Einölmaschine 34 erzeugt.

### Bezugszeichenliste

- 1: Anlage
- 2: Behandlungslinie (der Anlage 1)
- 10: Warmband
- 11: Erste Haspeleinrichtung
- 12: Zweite Haspeleinrichtung
- 14: Beizeinrichtung
- 16: Erste Beschichtungseinrichtung (elektrolytisch, oder mittels einer PVD-Anlage)
- 18: Erste Schere
- 20: Zweite Beschichtungseinrichtung
- 22: Dressiergerüst
- 23: Streckrichter
- 24: Zunderbrecher
- 26: Verbindungseinrichtung
- 28: Erster Schlingenspeicher
- 30: Zweiter Schlingenspeicher
- 32: Zweite Schere
- 34: Einölmaschine
- T: Bewegungsrichtung (des Warmbands 10 in der Behandlungslinie 2)

## Patentansprüche

1. Verfahren zum Beschichten eines verzunderten Warmbands (10), zumindest mit den Schritten:
(i) Bereitstellen eines Warmbands (10) in Form eines warmgewalztes Vorbands,
(ii) Vorbereiten der Oberflächen des Warmbands (10), und
(iii) Beschichten des Warmbands (10) an zumindest einer vorbereiteten Oberfläche davon, wobei das Beschichten bei einer Temperatur von ≤ 100 °C und unmittelbar nach dem Entzundern des Warmbands (10) durchgeführt wird,
**dadurch gekennzeichnet,**
**dass** nach dem Schritt (iii) für das Warmband (10) zumindest ein weiterer Behandlungsschritt (iv) durchgeführt wird, bei dem das Warmband (10) mit einer zusätzlichen Beschichtung bestehend aus einer Kunststoff-Folienkaschierung versehen wird.

2. Verfahren nach Anspruch 1, **dadurch gekennzeichnet, dass** beim Schritt (ii) das Vorbereiten des Warmbands (10) mittels einer Beizeinrichtung (14) durchgeführt wird.

3. Verfahren nach Anspruch 1 oder 2, **dadurch gekennzeichnet, dass** beim Schritt (iii) das Beschichten des Warmbands (10) elektrolytisch oder nach dem Prinzip einer physikalischen Gasphasenabscheidung (PVD) durchgeführt wird.

4. Verfahren nach einem der vorhergehenden Ansprüche, **dadurch gekennzeichnet, dass** das Warmband (10) vor dem Schritt (ii) an seinen Seitenrändern beschnitten wird.

5. Verfahren nach einem der vorhergehenden Ansprüche, **dadurch gekennzeichnet, dass** das Warmband (10) vor dem Schritt (ii) durch einen Streckrichter (24) geführt wird.

6. Anlage (1) zum Beschichten eines verzunderten Warmbands (10), umfassend eine durchlaufende Behandlungslinie (2), in der das Warmband (10) in einer Bewegungsrichtung (T) bewegt wird, wobei in der Behandlungslinie (2) eine Beizeinrichtung (14) zum Vorbereiten der Oberflächen des Warmbands (10) und zumindest eine erste Beschichtungseinrichtung (16) vorgesehen sind,
wobei mittels der ersten Beschichtungseinrichtung (16) auf zumindest eine vorbereitete Oberfläche des Warmbands (10) eine Beschichtung aufbringbar ist,
wobei die erste Beschichtungseinrichtung (16) derart ausgebildet ist, dass das Beschichten des Warmbands (10) an zumindest einer Seite davon bei einer Temperatur von ≤ 100 °C erfolgt,
**dadurch gekennzeichnet,**
**dass** eine zweite Beschichtungseinrichtung (20) vorgesehen ist, die - in der Bewegungsrichtung (T) des Warmbands (10) gesehen - stromabwärts der ersten Beschichtungseinrichtung (16) angeordnet ist, wobei mittels der zweiten Beschichtungseinrichtung (20) auf zumindest eine Oberfläche des Warmbands (10) eine zusätzliche Beschichtung bestehend aus einer Kunststoff-Folienkaschierung aufgebracht wird.

7. Anlage (1) nach Anspruch 6, **dadurch gekennzeichnet, dass** - in der Bewegungsrichtung (T) des Warmbands (10) gesehen - stromaufwärts der Beizeinrichtung (14) eine erste Schere (18) angeordnet ist, um damit Seitenränder des Warmbands (10) definiert abzuschneiden.

8. Anlage (1) nach Anspruch 6 oder 7, **dadurch gekennzeichnet, dass** ein Dressiergerüst (22) vorgesehen ist, das - in der Bewegungsrichtung (T) des Warmbands (10) gesehen - stromabwärts der ersten Beschichtungseinrichtung (16) angeordnet ist.

9. Anlage (1) nach einem der Ansprüche 6 bis 8, **dadurch gekennzeichnet, dass** ein Streckrichter (23) vorgesehen ist, der - in der Bewegungsrichtung (T) des Warmbands (10) gesehen - stromabwärts der ersten Beschichtungseinrichtung (16) angeordnet ist.

10. Anlage (1) nach einem der Ansprüche 6 bis 9, **dadurch gekennzeichnet, dass** ein Zunderbrecher (24) vorgesehen ist, der - in der Bewegungsrichtung (T) des Warmbands (10) gesehen - stromaufwärts der Beizeinrichtung (14) angeordnet ist.

11. Anlage (1) nach einem der Ansprüche 6 bis 10, **dadurch gekennzeichnet, dass** eine Verbindungseinrichtung (26) und eine erste Schlingenspeichereinrichtung (28) vorgesehen sind, die jeweils - in der Bewegungsrichtung (T) des Warmbands (10) gesehen - stromaufwärts der Beizeinrichtung (14) angeordnet sind.

12. Anlage (1) nach Anspruch 11, **dadurch gekennzeichnet, dass** eine zweite Schlingenspeichereinrichtung (30) und eine zweite Schere (32) vorgesehen sind, die jeweils - in der Bewegungsrichtung (T) des Warmbands (10) gesehen - stromabwärts der ersten Beschichtungseinrichtung (16) angeordnet sind.

13. Anlage (1) nach einem der Ansprüche 8 bis 12, **dadurch gekennzeichnet, dass** eine Einölmaschine (34) vorgesehen ist, die - in der Bewegungsrichtung (T) des Warmbands (10) gesehen - stromabwärts der zweiten Beschichtungseinrichtung (20) angeordnet ist.

14. Verwendung einer Anlage (1) nach einem der Ansprüche 6 bis 13, bei der die erste Beschichtungseinrichtung (16) außer Betrieb bleibt, so dass das Warmband (10) mittels der ersten Beschichtungseinrichtung (16) nicht beschichtet wird.

## Claims

1. Method of coating a scale-laden hot strip (10), at least with the steps of:
(i) providing a hot strip (10) in the form of a hot-rolled pre-strip,
(ii) preparing the surfaces of the hot strip (10) and
(iii) coating the hot strip (10) at at least one prepared surface thereof, wherein the coating is carried out at a temperature of ≤ 100° C and directly after descaling of the hot strip (10),
**characterised in that**
after the step (iii) at least one further treatment step (iv) is carried out for the hot strip (10) in which the hot strip (10) is provided with an additional coating consisting of a plastics material film covering.

2. Method according to claim 1, **characterised in that** the preparation of the hot strip (10) is carried out in the step (ii) by means of pickling equipment (14).

3. Method according to claim 1 or 2, **characterised in that** the coating of the hot strip (10) is carried out in the step (iii) electrolytically or in accordance with the principle of a physical gas phase deposition (PVD).

4. Method according to any one of the preceding claims, **characterised in that** the hot strip (10) is cut at its side edges before the step (ii).

5. Method according to any one of the preceding claims, **characterised in that** the hot strip (10) is conducted through a stretch-straightening device (24) before the step (ii).

6. Plant (1) for coating a scale-laden hot strip (10), comprising a continuous treatment line (2) in which the hot strip (10) is moved in a movement direction (T), wherein pickling equipment (14) for preparing the surfaces of the hot strip (10) and at least one first coating device (16) are provided in the treatment line (2),
wherein a coating can be applied by means of the first coating device (16) to at least one prepared surface of the hot strip (10),
wherein the first coating device (16) is so constructed that the coating of the hot strip (10) is carried out at at least one side thereof at a temperature of ≤ 100° C,
**characterised in that**
a second coating device (20), which as seen in the movement direction (T) of the hot strip (10) is arranged downstream of the first coating device (16), is provided, wherein an additional coating consisting of a plastics material film covering is applied to at least one surface of the hot strip (10)by means of the second coating device (20).

7. Plant (1) according to claim 6, **characterised in that** as seen in the movement direction (T) of the hot strip (10) first shears (18) are arranged upstream of the pickling equipment (14) so as to cut off side edges of the hot strip (10) in defined manner therewith.

8. Plant (1) according to claim 6 or 7, **characterised in that** a finished stand (22) which as seen in the movement direction (T) of the hot strip (10) is arranged downstream of the first coating device (16) is provided.

9. Plant (1) according to any one of claims 6 to 8, **characterised in that** a stretch-straightening device (23) which as seen in the movement direction (T) of the hot strip (10) is arranged downstream of the first coating device (16) is provided.

10. Plant (1) according to any one of claims 6 to 9, **characterised in that** a scale breaker (24) which as seen in the movement direction (T) of the hot strip (10) is arranged upstream of the pickling equipment (14) is provided.

11. Plant (1) according to any one claims 6 to 10, **characterised in that** a connecting device (26) and a first loop storage device (28) which as seen in the movement direction (T) of the hot strip (10) are each arranged upstream of the pickling equipment (14) are provided.

12. Plant (1) according to claim 11, **characterised in that** a second loop storage device (30) and second shears (32) which as seen in the movement direction (T) of the hot strip (10) are each arranged downstream of the first coating device (16) are provided.

13. Plant (1) according to any one of claims 8 to 12, **characterised in that** a lubricating machine (34) which as seen in the movement direction (T) of the hot strip (10) is arranged downstream of the second coating device (20) is provided.

14. Use of plant (1) according to any one of claims 6 to 13, in which the first coating device (6) remains out of operation so that the hot strip (10) is not coated by means of the first coating device (16).

## Revendications

1. Procédé destiné à l'enduction d'un feuillard chaud calaminé (10), qui comprend au moins les étapes dans lesquelles :
(i) on procure un feuillard chaud (10) sous la forme d'une amorce de démarrage laminée à chaud ;
(ii) on prépare les surfaces du feuillard chaud (10) ; et
(iii) on enduit le feuillard chaud (10) sur au moins une de ses surfaces qui ont été préparées ; dans lequel l'enduction est mise en oeuvre à une température égale ou inférieure à 100 °C et directement après le décalaminage du feuillard chaud (10) ;
**caractérisé en ce que**, après l'étape (iii), pour le feuillard chaud (10), on met en œuvre au moins une étape de traitement supplémentaire (iv) dans laquelle on munit le feuillard chaud (10) d'une enduction supplémentaire constituée d'un contrecollage d'une matière synthétique-feuille mince.

2. Procédé selon la revendication 1, **caractérisé en ce que**, au cours de l'étape (ii), on met en œuvre la préparation du feuillard chaud (10) au moyen d'un mécanisme de décapage (14).

3. Procédé selon la revendication 1 ou 2, **caractérisé en ce que**, au cours de l'étape (iii), on met en œuvre l'enduction du feuillard chaud (10) par voie électrolytique ou conformément au principe d'un dépôt physique en phase vapeur (PVD).

4. Procédé selon l'une quelconque des revendications précédentes, **caractérisé en ce que** l'on découpe le feuillard chaud (10), avant l'étape (ii), le long de ses bords latéraux.

5. Procédé selon l'une quelconque des revendications précédentes, **caractérisé en ce que** l'on guide le feuillard chaud (10), avant l'étape (ii), à travers une planeuse par étirage (24).

6. Installation (1) destinée à l'enduction d'un feuillard chaud calaminé (10), qui comprend une ligne de traitement continu (2), dans laquelle le feuillard chaud (10) est soumis à un déplacement dans une direction de déplacement (T) ; dans laquelle, dans la ligne de traitement (2) on prévoit un mécanisme de décapage (14) destiné à la préparation des surfaces du feuillard chaud (10) et au moins un premier mécanisme d'enduction (16) ; dans laquelle, au moyen du premier mécanisme d'enduction (16) on peut appliquer, sur au moins une surface préparée du feuillard chaud (10), une enduction ; dans laquelle le premier mécanisme d'enduction (16) est réalisé d'une manière telle que l'enduction du feuillard chaud (10) a lieu sur au moins un côté de ce dernier à une température égale ou inférieure à 100 °C ; **caractérisée en ce que** l'on prévoit un deuxième mécanisme d'enduction (20) qui - lorsqu'on regarde dans la direction de déplacement (T) du feuillard chaud (10) - est disposé en aval par rapport au premier mécanisme d'enduction (16) ; dans laquelle au moins moyen du deuxième mécanisme d'enduction (20) on applique, sur au moins une surface du feuillard chaud (10), une enduction supplémentaire qui est constituée d'un contrecollage d'une matière synthétique-feuille mince.

7. Installation (1) selon la revendication 6, **caractérisée en ce que** - lorsqu'on regarde dans la direction de déplacement (T) du feuillard chaud (10) - une première cisaille (18) est disposée en amont par rapport au mécanisme de décapage (14), à l'aide de laquelle on découpe d'une manière définie les bords latéraux du feuillard chaud (10).

8. Installation (1) selon la revendication 6 ou 7, **caractérisée en ce que** l'on prévoit une cage de dressage (22) qui - lorsqu'on regarde dans la direction de déplacement (T) du feuillard chaud (10) - est disposée en aval par rapport au premier mécanisme d'enduction (16).

9. Installation (1) selon l'une quelconque des revendications 6 à 8, **caractérisée en ce que** l'on prévoit une planeuse par étirage (23) qui - lorsqu'on regarde dans la direction de déplacement (T) du feuillard chaud (10) - est disposée en aval par rapport au premier mécanisme d'enduction (16).

10. Installation (1) selon l'une quelconque des revendications 6 à 9, **caractérisée en ce que** l'on prévoit un briseur de calamine (24) qui - lorsqu'on regarde dans la direction de déplacement (T) du feuillard chaud (10) - est disposé en amont par rapport au mécanisme de décapage (14).

11. Installation (1) selon l'une quelconque des revendications 6 à 10, **caractérisée en ce que** l'on prévoit un mécanisme de liaison (26) et un premier mécanisme (28) faisant office de fosse de bouclage, qui, de manière respective - lorsqu'on regarde dans la direction de déplacement (T) du feuillard chaud (10) - sont disposés en amont par rapport au mécanisme de décapage (14).

12. Installation (1) selon la revendication 11, **caractérisée en ce que** l'on prévoit un deuxième mécanisme (30) faisant office de fosse de bouclage et une deuxième cisaille (32) qui, de manière respective, - lorsqu'on regarde dans la direction de déplacement (T) du feuillard chaud (10) - sont disposés en aval par rapport au premier mécanisme d'enduction (16).

13. Installation (1) selon l'une quelconque des revendications 8 à 12, **caractérisée en ce que** l'on prévoit un mécanisme de huilage (34) qui - lorsqu'on regarde dans la direction de déplacement (T) du feuillard chaud (10) - est disposé en aval par rapport au deuxième mécanisme d'enduction (20).

14. Utilisation d'une installation (1) selon l'une quelconque des revendications 6 à 13, dans laquelle, le premier mécanisme d'enduction (16) est mis hors circuit, d'une manière telle que le feuillard chaud (10) n'est pas soumis à une enduction au moyen du premier mécanisme d'enduction (16).
